(19) Europäisches Patentamt
European Patent Office
Office européen des brevets

(11) Publication number: **0 299 641 B1**

(12) **EUROPEAN PATENT SPECIFICATION**

(45) Date of publication of patent specification: **10.06.92**

(51) Int. Cl.[5]: **C09D 183/10**, C08K 3/22, C08L 83/10

(21) Application number: **88305817.4**

(22) Date of filing: **27.06.88**

# (54) A curable composition.

(30) Priority: **17.07.87 US 74601**

(43) Date of publication of application:
**18.01.89 Bulletin 89/03**

(45) Publication of the grant of the patent:
**10.06.92 Bulletin 92/24**

(84) Designated Contracting States:
**DE FR GB NL**

(56) References cited:
**US-A- 3 965 065**
**US-A- 4 322 518**
**US-A- 4 450 255**
**US-A- 4 460 712**
**US-A- 4 537 829**

**PATENT ABSTRACTS OF JAPAN, vol. 11, no. 214 (C-434)[2661], 10th July 1987; & JP-A-62 32 157 (YOSHIO ICHIKAWA) 12-02-1987**

**WPI, FILE SUPPLIER, accession no. 78-03354A, Derwent Publications Ltd, London, GB; & JP-A-52 141 861 (HITACHI K.K.) 26-11-1977**

(73) Proprietor: **DOW CORNING CORPORATION**
**3901 S. Saginaw Road**
**Midland Michigan 48686-0994(US)**

(72) Inventor: **Fey, Kenneth Christopher**
**2605 Dilloway Drive**
**Midland Michigan(US)**

(74) Representative: **Kyle, Diana et al**
**Elkington and Fife Prospect House 8 Pembroke Road**
**Sevenoaks, Kent TN13 1XR(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 299 641 B1

## Description

The present invention relates to improved curable compositions. More particularly, the present invention relates to curable silicone coating compositions which provide improved corrosion resistance to metal surfaces, said compositions comprising (I) a liquid copolymeric organopolysiloxane, (II) a polydiorganosiloxane, (III) a particulate alumina filler and (IV) sufficient catalyst to cure said compositions.

In United States Patent No. 4,322,518, assigned to the assignee of the present invention, Blizzard discloses silicone coating compositions which comprise a solventless liquid copolymeric organopolysiloxane comprising a curable silicone polymer fluid or gum and a liquid $SiO_2$-based resin as the sole curing agent for the fluid or gum. When cured on various substrates, these silicone compositions provide release coatings having controllable release forces for adhesives adhered thereto.

Blizzard and Swihart, in United States Patent No. 4,537,829, assigned to the assignee of the present invention, teach compositions similar to those described by Blizzard, cited supra. In addition to the curable silicone polymer and liquid $SiO_2$-based resin, these compositions further comprise an organosilicon resin consisting essentially of dimethylvinylsiloxy units, trimethylsiloxy units and $SiO_{4/2}$ units and a hydrosilylation catalyst. These compositions, when cured, provided improved resistance to fuels and a high degree of corrosion protection to metal substrates.

It has now been found that certain compositions prepared according to the disclosures of Blizzard, cited supra, provide improved corrosion protection to metals, particularly ferrous metals, when cured on the surfaces thereof. It has also been discovered that the incorporation of up to about 50% by weight of alumina or hydrated alumina in these compositions further augments the corrosion resistance of metals coated with the cured compositions. Surprisingly, incorporation of like proportions of hydrated alumina in the compositions taught by Blizzard and Swihart, cited supra, did not result in such improvements.

The present invention therefore relates to a composition comprising:

(I) from 1 to 99 parts by weight of a liquid organopolysiloxane copolymer, prepared by a method comprising (A) forming a homogeneous mixture having an acid number greater than zero and consisting essentially of (a) an organic solvent solution of a resinous copolymeric siloxane containing silicon-bonded hydroxyl radicals and consisting essentially of $R_3SiO_{1/2}$ units and $SiO_{4/2}$ units wherein the ratio of $R_3SiO_{1/2}$ units to $SiO_{4/2}$ units is 0.6:1 to 0.9:1 and each R denotes, independently, a monovalent hydrocarbon radical and (b) a liquid organohydrogenpolysiloxane wherein each organic radical is , independently, a monovalent hydrocarbon radical, there being an average of at least one silicon-bonded hydrogen radical per molecule of said organohydrogenpolysiloxane, and (B) heating said homogeneous mixture to remove substantially all of said organic solvent therefrom;

(II) from 99 to 1 parts by weight of a hydroxy-functional diorganopolysiloxane having the average formula $(HO)R'''_2SiO(R'''_2SiO)_cSiR'''_2(OH)$ wherein $R'''$ is a group independetly selected from alkyl, cycloalkyl, haloalkyl, aromatic or haloaromatic radicals and c has a value sufficient to provide a viscosity of about 1 to 1,000,000 Poise at 25° C. for the diorganopolysiloxane;

(III) from 1 to 100 parts by weight, per 100 parts of said component (I) plus component (II), of a particulate filler selected from alumina, alumina monohydrate or alumina trihydrate; and

(IV) sufficient catalyst to cure said composition to a non-flowing state.

This invention further relates to a similar composition to that described above, wherein said component (I) is prepared by simply mixing said components (a) and (b) without subsequent heating and removal of solvent therefrom.

This invention still further relates to a method of coating a metal substrate with either of the above described compositions and subsequently curing said composition to a non-flowing state.

Component (I) of the compositions of this invention is a liquid copolymeric organopolysiloxane. It may be prepared by reacting (a) a resinous copolymeric siloxane with (b) a liquid organohydrogenpolysiloxane. Alternatively, component (I) may be prepared by simply blending reactants (a) and (b) and using this mixture directly in the compositions of the present invention.

Component (a) that is used to prepare the liquid copolymeric organopolysiloxane (I) is an organic solvent solution of a resinous copolymeric siloxane which consists essentially of $R_3SiO_{1/2}$ siloxane units and $SiO_{4/2}$ siloxane units in a molar ratio which provides from 0.6 to 0.9 $R_3SiO_{1/2}$ units for every $SiO_{4/2}$ unit. Each R denotes a monovalent hydrocarbon radical; such as an alkyl radical, such as methyl, ethyl, isopropyl, butyl and hexyl; an alkenyl radical, such as vinyl and allyl; and aryl radical, such as phenyl, tolyl and xylyl; an arylalkyl radical, such as beta-phenylethyl and beta-phenylpropyl; and a cycloaliphatic radical, such as cyclopentyl, and cyclohexyl. Preferably, all R radicals in component (a) are lower alkyl radicals although a minor portion of them can be replaced with other monovalent hydrocarbon radicals such as the vinyl radical and/or the phenyl radical to provide additional properties for the resinous copolymer such as

the reactivity attendant therewith.

In a preferred curable coating composition of this invention the resinous copolymeric siloxane portion of component (a) consists essentially of $(CH_3)_3SiO_{1/2}$ siloxane units and $SiO_{4/2}$ siloxane units, in the molar ratio of about 0.75:1.

Resinous copolymeric siloxanes consisting of $R_3SiO_{1/2}$ units and $SiO_{4/2}$ units are well known in the art and are described by, for example, Daudt et al., U.S. Patent No. 2,676,182.

Resinous copolymeric siloxanes are typically prepared in an organic solvent which can conveniently serve as the organic solvent portion of component (a). The particular organic solvent portion of component (a) is not critical and can be, for example, an aliphatic hydrocarbon, an aromatic hydrocarbon or halogenated derivatives of either, or mixtures thereof. Particularly useful organic solvents include benzene, toluene, xylene, trichloroethylene and mineral spirits.

Component (b) that is used to prepare the liquid copolymeric organopolysiloxane (I) is any liquid organohydrogenpolysiloxane containing an average of at least one silicon-bonded hydrogen radical per molecule, and can have a linear, cyclic or branched structure or combinations thereof. Thus, component (b) has the unit formula $R'_mH_nSiO_{(4-m-n)/2}$ wherein m and n denote positive numbers whose sum is less than 4, preferably from 1.9 to 2.1. The organic radicals (R') in component (b) can be any of the R radicals denoted above. Preferably, although not necessarily, the organic radicals (R') in component (b) are the same as the organic radicals (R) in component (a).

Examples of organohydrogenpolysiloxanes that are suitable for use as component (b) include cyclic organohydrogenpolysiloxanes of the unit formula $R'_mH_{2-m}SiO$ such as $[(CH_3)(H)SiO]_x$ wherein x is 3, 4, 5, 6 and higher and $[(CH_3)(H)SiO]_y[(CH_3)_2SiO]_z$ wherein the sum of y plus z is 3, 4, 5, 6 and higher, and linear organohydrogenpolysiloxanes of the formula $R''R'_2SiO(R'_2SiO)_a(R'HSiO)_bSiR'_2R''$, such as $R''(CH_3)_2SiO[(CH_3)_2SiO]_a[(CH_3(H)SiO]_bSi(CH_3)_2R''$ wherein R'' denotes H or methyl and a and b each denote zero or a number greater than zero, provided there is at least one silicon-bonded hydrogen radical per molecule, such as

$H(CH_3)_2SiO[(CH_3)_2SiO]_aSi(CH_3)_2H$,
$(CH_3)_3SiO[(CH_3)(H)SiO]_bSi(CH_3)_3$,
$(CH_3)_3SiO[(CH_3)(H)SiO]_b[(CH_3)_2SiO]_aSi(CH_3)_3$ and
$H(CH_3)_2SiO[(CH_3)_2SiO]_a[(CH_3)(H)SiO)]_bSi(CH_3)_2H$.

An organohydrogenpolysiloxane having the formula $(CH_3)_3SiO[(CH_3)(H)SiO]_bSi(CH_3)_3$ wherein b has an average value of from 30 to 70 is a highly preferred component (b). It is particularly preferred that b is about 35.

Component (I) of the present invention, preparation of which is described infra, preferably consists essentially of a devolatilized reaction product of components (a) and (b).

On a solids basis, the organohydrogenpolysiloxane (i.e., component b) content of component (I) varies between 10 and 90 weight percent of the total blend or reaction product. Preferably, the organohydrogenpolysiloxane content of component (I) varies between 40 and 60 weight percent and most preferably it is about 50 weight percent on a solids basis. Herein, the term "solids basis" denotes the non-solvent content of any composition or component.

When component (I) is a reaction product of components (a) and (b), a homogeneous mixture is formed by thoroughly mixing the desired amounts of component (a) and component (b) and, if necessary, an acid, preferably a strong acid such as hydrochloric acid, to provide an acid number greater than zero therefor. Preferably, the acid number of the homogeneous mixture, on a solids basis, has a value of from 0.1 to 1. Preferably, component (a) is sufficiently acidic, as prepared, to provide this acidity for the homogeneous mixture. Herein, acid number is the number of mg of potassium hydroxide required to neutralize 1 gram of sample (solids basis) using Bromocresol Purple as the acid/base indicator.

The resulting homogeneous mixture is immediately or subsequently heated to volatilize the organic solvent therefrom. Said heating is preferably initially done at atmospheric pressure and is then continued at reduced pressure to accelerate the removal of said solvent.

In a preferred embodiment of this invention the homogeneous mixture of (a) plus (b) is heated to about 150° C. at atmospheric pressure and is then subjected to a gradually decreasing pressure, without an increase in temperature, to remove substantially all of the organic solvent therefrom. By substantially it is meant herein that the liquid copolymeric organopolysiloxane contains less than about 5 percent, and preferably less than about 1 percent, by weight organic solvent.

Alternatively, the homogeneous mixture can be partially devolatilized at room temperature, such as by evaporation, and the partially devolatilized mixture then heated to remove substantially all of the organic

solvent therefrom.

The liquid copolymeric organopolysiloxanes (I) contain silicon-bonded hydroxyl radicals and/or silicon-bonded hydrogen radicals which provide chemical reactivity therefor in the compositions of this invention.

Further details dealing with the preparation of component (I) by this method, as well as descriptions of components (a) and (b), may be found in U.S. Patent No. 4,322,518, cited supra.

When component (I) is a room temperature blend of components (a) and (b), its preparation simply consists of forming a homogeneous solution between these ingredients. As in the case of the reaction product, described above, an acid number greater than zero is required and an acid number between about 0.1 and 1, on a solids basis, is preferred.

Component (II) of this invention is a polydiorganosiloxane having the general formula

$$(HO)R'''_2SiO(R'''_2SiO)_cSiR'''_2(OH)$$

wherein $R'''$ denotes a monovalent hydrocarbon radical independently selected from the group of R radicals indicated above for component (I). For the purpose of this invention, at least 95 percent of the $R'''$ radicals are methyl (Me) and it is preferred that all $R'''$ radicals are methyl. Herein, c has an average value which is sufficient to provide a viscosity for component (II) of 1 to 1,000,000 Poise at 25° C. Preferably, the viscosity of component (II) is about 200,000 Poise at 25° C. and this component is ordinarily dissolved in a solvent, such as toluene, xylene, naptha spirits, VMP naptha, low molecular weight ketones or hexane, before combining with components (I) and (III) of this invention.

A highly preferred component (II) is a mixture of (1) about 7 parts by weight of a hydroxyl endblocked polydimethylsiloxane having an approximate average molecular weight of 40,000 which contains less than about 2 weight percent of a mixture of cyclic polydimethylsiloxanes having a degree of polymerization ranging from 3 to 40 with (2)1 part of a silanol-ended polydimethylsiloxane gum having a viscosity of about 100,000 Poise at 25° C. and containing about 1% pyrogenic silica and 1 part of the liquid organohydrogen-polysiloxane

$$(CH_3)_3SiO[(CH_3)(H)SiO]_{35}Si(CH_3)_3.$$

As noted above, this preferred component (II) is ordinarily added in the form of a solution in forming the compositions of this invention.

Polydiorganosiloxanes which are suitable for use as component (II) are well known in the art and many of these fluids or gums are available commercially. Therefore, further description of methods for the preparation of such materials is not detailed herein.

Component (III) of the present invention is a particulate alumina or hydrated alumina having the general formula

$$Al_2O_3 \cdot x(H_2O)$$

wherein x is 0, 1 or 3. It is preferred that this filler have a uniform particle size and an average diameter of about 1 micron or less. Most preferably, component (III) is alumina trihydrate (i.e., x = 3) having a uniform particle diameter averaging about 1 micron.

The alumina fillers of component (III) are well known in the art and are commercially available, hence further description of methods of preparation will not be addressed herein.

Component (IV) of the present invention is a curing amount of a curing catalyst. Catalysts suitable for use in this invention include any of the compounds which are known to facilitate the condensation reactions between SiOH groups and between SiOH and SiH groups. For example, the catalysts contemplated may be salts of heavy metals, such as dibutyltin diacetate and stannous octoate. These catalysts, and their use in promoting the above-mentioned reactions, are well known in the art.

The compositions of this invention can further comprise typical silicone adjuvants such as catalysts, fillers, pigments, dyes and cure-control additives, if desired.

The compositions of this invention are prepared by thoroughly mixing, on a solids basis, from 1 to 99 parts by weight, preferably from 15 to 25 parts, of component (I), from 99 to 1 parts by weight, preferably from 85 to 75 parts, of component (II) and, based on 100 parts by weight of component (I) plus component (II), from 1 to 100 parts by weight of component (III). This corresponds to an alumina (or alumina hydrate) content of 0.5 to 50 weight percent based on total silicone polymer content. It is preferred that component (III) is employed in the range of 10 to 80 parts by weight based on 100 parts (solids basis) of component (I) plus component (II). It has been found that when much more than approximately 100 parts of the alumina

filler per 100 parts of total silicone polymer is used (e.g., about 150 parts per 100 parts of I plus II), the resultant coatings are inferior in that filler particles on the surface are not completely coated with the silicone components and such compositions tend to be abrasive and weak. This has been observed in Taber abrasion measurements wherein such highly filled coatings are readily worn down. On the other hand, compositions containing as high a level of alumina trihydrate as is consistent with corrosion protection characteristics benefit from the reduced cost and improved fire retardancy imparted by this filler.

In highly preferred compositions of the present invention, about 21 parts by weight of the preferred devolatilized reaction product, described supra as component (I), is combined with about 79 parts by weight of the preferred component (II), each being measured on a solids basis. The preferred filler (component III), alumina trihydrate, is incorporated at about 17 to about 67 parts by weight per 100 parts of total solids of components (I) plus (II). These embodiments are catalyzed with approximately 5% of dibutyltin diacetate, based on the total solids of components (I) and (II).

Any of the high shear mixers commonly employed in the art may be used to disperse the filler. Examples of such mixers include Ross, Jiffy and Meyers mixtures. As far as is known, the order of mixing is not critical to the operability of this invention as long as the filler is thoroughly dispersed in components (I) and (II). It is preferred, however, to first disperse the filler (component III) in component (II) and then to mix in component (I), again using high shear to obtain a good dispersion. It is further preferred to pre-treat the alumina filler with a portion (typically about 2%) of component (I) before mixing this with the rest of component (I) and component (II). This pre-treatment may be carried out, for example, by rolling the filler, the portion of component (I) and an inert, volatile organic solvent for (I) in a ball mill. After rolling, the treated filler dispersion is dried to remove the solvent before forming the compositions of this invention.

Sufficient catalyst (component IV) to allow cure of the composition to a non-flowing state is generally added just before the compositions are to be used (cured). In this connection, it has been found that even when the compositions are not catalyzed they should not be allowed to age for long periods before using. Thus, it was observed that coatings formed from such compositions which are aged at room temperature for one week before being catalyzed, coated onto steel panels and cured thereon, were inferior to those prepared from fresh compositions. It is, therefore, preferred to store the compositions of the present invention as three separate components, to be mixed just before use: (1) filler (i.e., component III) dispersed in component (II), (2) component (I) and (3) catalyst. Of course, solvent may be added to any of these for handling convenience.

The compositions of the present invention may be employed in electronic applications, such as circuit board coatings and conformal coatings, or for the fabrication of gaskets to be used in connecting dissimilar metals. They find particular utility as protective coating compositions for metal substrates. When applied as 100% solids or from solution and cured on such substrates as iron, steel, aluminum, brass or copper, coatings comprising these compositions provide improved corrosion protection to the substrates. This is particularly true for the case of ferrous metals exposed to moisture and salt.

To form such coating compositions, the compositions of this invention are typically diluted with a sufficient quantity of a good solvent for components (I) and (II) in order to provide a desired coating composition viscosity. Such solvents as hexane, heptane, toluene, xylene, mineral spirits or ketones are suitable for this purpose, xylene being preferred. Alternatively, a 100% solids system is also contemplated herein, particularly when component (II) has a low viscosity.

The coating compositions of this invention may be applied to metal surfaces by any of the methods commonly practiced in the coating arts. For example, substrates may be dipped, brushed, sprayed or flow coated. Optimal amounts of solvent and catalyst to be included in such coating compositions may readily be determined by routine experimentation.

After coating of the metal substrates with the coating compositions of this invention, the coatings, which typically are at least about 1 mil in thickness, are cured, preferably at elevated temperatures such as 125 to 150 °C. Alternatively, when sufficient catalyst is used, the compositions of the present invention can be cured at room temperature.

The following examples are presented to further illustrate the compositions of this invention, but are not to be construed as limiting the invention, which is delineated in the appended claims. All parts and percentages in the examples are on a weight basis unless indicated to the contrary and viscosities are measured at 25 °C.

The following components were used to prepare the compositions of this invention.

FLUID A - A 70% xylene solution of a siloxane resin copolymer consisting essentially of $(CH_3)_3SiO_{1/2}$ units and $SiO_{4/2}$ units in a molar ratio of approximately 0.75:1.

FLUID B - A liquid organohydrogenpolysiloxane having the average formula

$$Me_3SiO(\underset{H}{MeSiO})_{35}SiMe_3$$

wherein Me denotes the methyl radical.

FLUID C - A liquid organopolysiloxane copolymer was prepared according to the methods of United States Patent No. 4,310,678 wherein 59 parts of FLUID A was thoroughly mixed with 41 parts of FLUID B using a nitrogen purge. Xylene solvent was removed as this mixture was heated under a vacuum of about 100 mm Hg at 150° C. for 2 hours to yield a reaction product containing a 1:1 weight ratio of the siloxane resin copolymer to the organohydrogenpolysiloxane.

FLUID D - A solution consisting of 34 parts of a silanol-ended polydimethylsiloxane gum having a viscosity of about 100,000 Poise and containing about 1% pyrogenic silica, 1 part of the liquid organohydrogenpolysiloxane used in FLUID B and 65 parts of xylene, was prepared.

FLUID E - A hydroxy-endblocked polydimethylsiloxane having an approximate number average molecular weight of 40,000 which contained less than 2 weight percent of a mixture of dimethylcyclopolysiloxanes having a degree of polymerization ranging from 3 to 40.

ATH- A precipitated alumina trihydrate filler having a uniform average particle size of approximately one micron in diameter and obtained from the Aluminum Company of America (Pittsburgh, PA) under the trade name HYDRAL 710.

In the following examples, component (II) of the compositions of the present invention comprises a mixture of the hydroxyl-functional polydimethylsiloxanes of FLUID D and FLUID E.

Examples 1 - 3

These examples illustrate the effect of varying the ATH content of the compositions of the present invention. In these examples component (I) is FLUID C, a devolatilized reaction product of FLUID A and FLUID B. On a solids basis, the ratio of component (II) to component (I) employed in Examples 1-3 was 86:14.

Proportions of the components of Examples 1 and 2 are shown in Table 1, below. The mixing procedure consisted of first preparing a treated ATH (alumina trihydrate). A mixture of 1 gram of FLUID C, 210 grams of hexane and 50 grams of ATH was rolled in a polyethylene jar containing 1/2 inch ceramic pebbles for about 24 hours. The hexane solvent was then removed from this combination by drying the filler at room temperature followed by heating at 150° C. for 1/2 hour, to form the treated ATH used in these compositions. This pre-treated ATH was mixed with FLUID D and FLUID E (i.e., component II) in a JIFFY high shear mixer till a uniform dispersion resulted. FLUID C was then added and mixed in at high shear. A similar composition, but without the alumina trihydrate filler, was prepared by simply stirring components (I) and (II) together to obtain a homogenous solution, shown in Table 1 as (Comparative) Example 3. At this point, the calculated alumina trihydrate contents (solids basis) of the compositions of Example 1 and Example 2 were 18 and 67 parts ATH per 100 parts of component (I) plus component (II), respectively (15% and 40%, respectively).

The above described ingredients were combined with additional xylene solvent (to provide a flowable consistency for subsequent coating of steel panels) and catalyzed with 5 percent (based on total silicone content) of dibutyltindiacetate (DBTDA) to form the compositions of this invention, as shown in Table 1.

Table 1

| | Grams ATH | Grams FLUID C | Grams FLUID D | Grams FLUID E | Grams Xylene | Grams DBTDA |
|---|---|---|---|---|---|---|
| Ex. 1 | 10.0 | 8.0 | 17.6 | 42.5 | 17.4 | 2.8 |
| Ex. 2 | 21.4 | 4.5 | 9.3 | 24.1 | 30.1 | 1.6 |
| (Comparative) Ex. 3 | --- | 6.2 | 12.0 | 31.3 | 10.1 | 2.1 |

The catalyzed compositions of Examples 1 - 3 were coated onto pre-cleaned cold-rolled steel panels using a 6 mil wet gap draw down bar. The resulting coatings were allowed to partially cure at room temperature (R.T.) for about 15 - 60 minutes, till they were tack-free, and were then further cured in an air oven at 150° C. for 5 minutes. Cured film thicknesses ranged from 0.6 to 0.9 mil.

Corrosion resistance was evaluated by ASTM test method D1654, wherein a 2 inch-long scribe line was

cut in each coated panel to expose a fine line of bare metal. The scribed panels were then subjected to salt spray (fog) testing according to ASTM test method B117, using a sodium chloride concentration of 2.5% at a temperature of 35 ° C. Before placing the coated panels in the salt spray apparatus, the edges of each panel were covered with Mylar pressure-sensitive tape which was then further sealed with paraffin wax in order to eliminate edge corrosion effects. After being exposed for the times indicated in Table 2, below, the panels were rinsed with water and then evaluated.

Results showing average corrosion "creep" at the scribe line after various exposure times are reported in Table 2, below. In this table, a rating of 10 represents zero creep (i.e., initial rating before exposure) and a rating of 0 represents greater than a 5/8 inch (greater than 16 mm) scribe creep, wherein the scribe creep is defined as the average perpendicular distance from the scribe line where rust was detected. There was no surface rusting, staining or blistering observed on any of the panels in the non-scribed areas (i.e., a surface rust rating of 10 for all samples according to ASTM test method D610). Results of these measurements indicate that the coatings based on the compositions of this invention exhibit significantly less scribe creep than the control formulation having no aluminum trihydrate filler and are, therefore, more resistant to corrosion.

Table 2

| Coating Composition | Creep Rating per ASTM D1654 | | | |
|---|---|---|---|---|
| | 48 hr | 120 hr | 288 hr | 1,266 hr |
| Example 1 | 9 | 7 | 5 | 5 |
| Example 2 | 9 | 8 | 6 | 5 |
| (Comparative) Example 3 | 8 | 4 | 2 | 1 |

In addition to the above evaluation, the amount of "undercutting" of each coating was observed as a function of salt spray exposure time. While the panels were still wet from the salt spray chamber, the amount of "undercutting" was measured by gently probing the surface of each panel with a spatula tip to determine the farthest point from the end of the scribe line at which the coating had delaminated (separated) from the steel substrate (i.e., where either movement of the coating or color change could be detected). The boundary so defined represents an unprotected area, beyond that delineated by the above described rust creep, wherein the substrate is more vulnerable to corrosion than where the coating is firmly adhered to the substrate. Results of these measurements (Table 3) indicate that the coatings based on the compositions of this invention exhibit significantly less undercutting than the control formulation having no alumina trihydrate filler and are, therefore, less susceptible to further corrosion.

Table 3

| Coating Composition | Maximum Extent of Undercutting After Salt Spray Exposure (inches) | | | | |
|---|---|---|---|---|---|
| | 348 hr | 552 hr | 690 hr | 1,026 hr | 1,266 hr |
| Example 1 | 3/32 | 1/8 | 1/8 | 1/4 | 3/16 - 1/4 |
| Example 2 | 1/16 | 1/8 | 3/16 | 1/8 | 1/8 - 1/4 |
| (Comparative) Example 3 | 7/16 | 5/8 | 5/8 | 7/8 | ---- |

Examples 4 - 7

The following examples illustrate the effect of varying the ratio of component (II) to component (I) at a constant ATH level in the compositions of the present invention. Mixing procedures similar to those described in Examples 1 and 2 were followed except that the ATH was not pre-treated. These compositions, which each contained 67 parts ATH per 100 parts of component (I) plus component (II) (40% ATH) on a solids basis before being catalyzed, are shown in Table 4, below. In Examples 4, 5 and 6, the ratio of component (II) to component (I), on a solids basis, was calculated as 93:7, 86:14 and 79:21, respectively. For comparison, a composition containing no ATH, (Comparative) Example 7, was prepared in the manner described in (Comparative) Example 3, above, wherein the ratio of component (II) to component (I) was

again 86:14. These compositions were diluted with xylene and catalyzed with DBTDA, as shown in Table 4 below, just before coating test panels.

Table 4

| | Grams ATH | Grams FLUID C | Grams FLUID D | Grams FLUID E | Grams Xylene | Grams DBTDA |
|---|---|---|---|---|---|---|
| Ex. 4 | 136.0 | 14.5 | 64.0 | 167.0 | 192.0 | 10.0 |
| Ex. 5 | 136.0 | 29.0 | 59.0 | 154.0 | 192.0 | 10.0 |
| Ex. 6 | 136.0 | 43.4 | 54.1 | 141.1 | 192.0 | 10.0 |
| (Comparative) Ex. 7 | --- | 29.0 | 59.0 | 154.0 | 30.0 | 10.0 |

Examples 8 - 10

These examples illustrate the use of cold-blended (i.e., unreacted) component (I) with various levels of ATH to form the compositions of the present invention. In these examples, the ATH was not pre-treated but was otherwise dispersed in component (II) as above. A blend of FLUID A and FLUID B (i.e., component I), having a solids basis ratio of 1:1 of the siloxane resin copolymer to the organohydrogenpolysiloxane, was added to this dispersion as shown in Table 5, below. Additionally, (Comparison) Example 10 containing no ATH was prepared by stirring components (I) and (II) together as in previous comparison examples. Each of these examples had a calculated ratio of component (II) to component (I), on a solids basis, of about 86:14. The calculated ATH contents (solids basis, before catalyst addition) of Examples 8 and 9 were 17 and 67 parts ATH per 100 parts of component (I) plus component (II), respectively (15% and 40%, respectively). As before, xylene and catalyst were added to each composition just before coating test panels.

Table 5

| Composition | Grams ATH | Grams FLUID A | Grams FLUID B | Grams FLUID D | Grams Fluid E | Grams Xylene | Grams DBTDA |
|---|---|---|---|---|---|---|---|
| Ex. 8 | 35.4 | 20.7 | 14.5 | 59.0 | 154.0 | 63.0 | 10.0 |
| Ex. 9 | 136.0 | 20.7 | 14.5 | 59.0 | 154.0 | 192.0 | 10.0 |
| (Comparative) Ex. 10 | --- | 20.7 | 14.5 | 59.0 | 154.0 | 30.0 | 10.0 |

The compositions of Examples 4 - 10 were coated onto cold-rolled steel panels, as described above, and were allowed to air-cure for 7 days at room temperature, after which they were further cured for 20 minutes at 149 °C. The coatings were subjected to salt spray exposure, as above, after an "X" was scribed in the cured film per ASTM test method D1654. Table 6 shows observed scribe creep ratings (10 = initial rating) after 288 hours of exposure. Also shown is the surface rust rating (10 = initial rating) according to ASTM D610.

Table 6

| Creep Ratings per ASTM D1654 | | | |
|---|---|---|---|
| Composition | Dry Film Thickness (mil) | Creep Rating | Surface Rust Rating |
| Ex. 4 | 0.7 | 4 | 10 |
| Ex. 5 | 0.65 | 6 | 10 |
| Ex. 6 | 0.7 | 6.5 | 10 |
| (Comparative) Ex. 7 | 0.7 | 0 | 9 |
| Ex. 8 | 0.7 | 5.5 | 9.5 |
| Ex. 9 | 0.75 | 5 | 9.5 |
| (Comparative) Ex. 10 | 0.75 | 1 | 8.5 |

It can be seen that the compositions of the present invention provide improved corrosion protection to the steel substrates relative to compositions containing no ATH.

When coatings containing comparable amounts of ATH dispersed in silicone compositions taught by Blizzard and Swihart, U.S. Patent No. 4,537,829, cited supra, were evaluated after 288 hours of salt spray exposure, it was found that these lacked the excellent undercutting characteristics of the compositions of the present invention. After about 1000 hours of exposure, these comparative systems also displayed considerably more scribe creep than the compositions of the present invention.

**Claims**

**1.** A curable composition comprising:

(I) from 1 to 99 parts by weight of a liquid organopolysiloxane copolymer, prepared by a method comprising (A) forming a homogeneous mixture having an acid number greater than zero and consisting essentially of (a) an organic solvent solution of a resinous copolymeric siloxane containing silicon-bonded hydroxyl radicals and consisting essentially of $R_3SiO_{1/2}$ units and $SiO_{4/2}$ units wherein the ratio of $R_3SiO_{1/2}$ units to $SiO_{4/2}$ units is 0.6:1 to 0.9:1 and each R denotes, independently, a monovalent hydrocarbon radical and (b) a liquid organohydrogenpolysiloxane wherein each organic radical is , independently, a monovalent hydrocarbon radical, there being an average of at least one silicon-bonded hydrogen radical per molecule of said organohydrogenpolysiloxane, and (B) heating said homogeneous mixture to remove substantially all of said organic solvent therefrom;

(II) from 99 to 1 parts by weight of a hydroxy-functional diorganopolysiloxane having the average formula $(HO)R'''_2SiO(R'''_2SiO)_cSiR'''_2(OH)$ wherein $R'''$ is a group independently selected from alkyl, cycloalkyl, haloalkyl, aromatic or haloaromatic radicals and c has a value sufficient to provide a viscosity of about 1 to 1,000,000 Poise at 25° C. for the diorganopolysiloxane;

(III) from 1 to 100 parts by weight, per 100 parts of said component (I) plus component (II), of a particulate filler selected from alumina, alumina monohydrate or alumina trihydrate; and

(IV) sufficient catalyst to cure said composition to a non-flowing state.

**2.** A curable composition comprising:

(I) from 1 to 99 parts by weight, on a solids basis, of a liquid organopolysiloxane copolymer, prepared by a method comprising forming a homogeneous mixture having an acid number greater than zero and consisting essentially of (a) an organic solvent solution of a resinous copolymeric siloxane containing silicon-bonded hydroxyl radicals and consisting essentially of $R_3SiO_{1/2}$ units and SiO4/2 units wherein the ratio of $R_3SiO_{1/2}$ units to $SiO_{4/2}$ units is 0.6:1 to 0.9:1 and each R denotes, independently, a monovalent hydrocarbon radical and (b) a liquid organohydrogenpolysiloxane wherein each organic radical is, independently, a monovalent hydro-carbon radical, there being an average of at least one silicon-bonded hydrogen radical per molecule of said organohydrogenpolysiloxane;

(II) from 99 to 1 parts by weight of a hydroxy-functional diorganopolysiloxane having the average formula $(HO)R'''_2SiO(R'''_2SiO)_cSiR'''_2(OH)$ wherein $R'''$ is a group independently selected from alkyl, cycloalkyl, haloalkyl, aromatic or haloaromatic radicals and c has a value sufficient to provide a viscosity of about 1 to 1,000,000 Poise at 25° C. for the diorganopolysiloxane;

(III) from 1 to 100 parts by weight, per 100 parts of said component (I) plus component (II), of a particulate filler selected from alumina, alumina monohydrate or alumina trihydrate; and

(IV) sufficient catalyst to cure said composition to a non-flowing state.

**3.** A metal substrate bearing the cured composition of claim 1.

**4.** A method of coating a metal substrate with a curable composition and subsequently curing said composition to a non-flowing state, characterised in that the composition of claim 1 is used as said curable composition.

**Revendications**

**1.** Une composition durcissable comprenant :

(I) de 1 à 99 parties en poids d'un copolymère organopolysiloxane liquide, préparé par un procédé comprenant (A) la formation d'un mélange homogène ayant un indice d'acide supérieur à zéro et formé essentiellement (a) d'une solution dans un solvant organique d'un siloxane copolymère résineux renfermant des radicaux hydroxyle liés au silicium et constitué essentiellement de motifs $R_3SiO_{1/2}$ et de motifs $SiO_{4/2}$ dans lequel le rapport des motifs $R_3SiO_{1/2}$ aux motifs $SiO_{4/2}$ est de 0,6:1 à 0,9:1, chaque R désignant, indépendamment, un radical hydrocarboné monovalent, et (b) d'un organohydrogénopolysiloxane liquide dans lequel chaque radical organique est, indépendamment, un radical hydrocarboné monovalent, ledit organohydrogénopolysiloxane renfermant une moyenne d'au moins un radical hydrogène lié au silicium par molécule, et (B) le chauffage dudit mélange homogène à l'effet d'en éliminer sensiblement en totalité ledit solvant organique ;

(II) de 99 à 1 parties en poids d'un diorganopolysiloxane hydroxyfonctionnel de formule moyenne $(HO)R'''_2SiO(R'''_2SiO)_cSiR'''_2(OH)$ dans lequel R''' est un groupe choisi indépendamment parmi les radicaux alkyles, cycloalkyles, halogénoalkyles, aromatiques et halogénoaromatiques et c a une valeur suffisante pour conférer au diorganopolysiloxane une viscosité d'environ 1 à 1 000 000 poises à 25 °C ;

(III) de 1 à 100 parties en poids, pour 100 parties du total des constituants (I) et (II) ci-dessus, d'une charge particulaire choisie parmi l'alumine, l'alumine monohydratée et l'alumine trihydratée : et

(IV) suffisamment de catalyseur pour amener par durcissement ladite composition dans un état non-coulant.

**2.** Une composition durcissable comprenant :

(I) de 1 à 99 parties en poids, sur la base de la matière sèche, d'un copolymère organopolysiloxane liquide, préparé par un procédé comprenant la formation d'un mélange homogène présentant un indice d'acide supérieur à zéro et formé essentiellement (a) d'une solution dans un solvant organique d'un siloxane copolymère résineux renfermant des radicaux hydroxyle liés au silicium et constitué essentiellement de motifs $R_3SiO_{1/2}$ et de motifs $SiO_{4/2}$ dans lequel le rapport des motifs $R_3SiO_{1/2}$ aux motifs $SiO_{4/2}$ est de 0,6:1 à 0,9:1, chaque R désignant, indépendamment, un radical hydrocarboné monovalent, et (b) d'un organohydrogénopolysiloxane liquide dans lequel chaque radical organique est, indépendamment, un radical hydrocarboné monovalent, ledit organohydrogénopolysiloxane renfermant une moyenne d'au moins un radical hydrogène lié au silicium par molécule ;

(II) de 99 à 1 parties en poids d'un diorganopolysiloxane hydroxyfonctionnel de formule moyenne $(HO)R'''_2SiO(R'''_2SiO)_cSiR'''_2(OH)$ dans lequel R''' est un groupe choisi indépendamment parmi les radicaux alkyles, cycloalkyles, halogénoalkyles, aromatiques et halogénoaromatiques et c a une valeur suffisante pour conférer au diorganopolysiloxane une viscosité d'environ 1 à 1 000 000 poises à 25 °C ;

(III) de 1 à 100 parties en poids, pour 100 parties du total des constituants (I) et (II) ci-dessus, d'une charge particulaire choisie parmi l'alumine, l'alumine monohydratée et l'alumine trihydratée : et

(IV) suffisamment de catalyseur pour amener par durcissement ladite composition dans un état non-coulant.

**3.** Un substrat métallique portant la composition durcie de la revendication 1.

**4.** Un procédé de revêtement d'un substrat métallique par une composition durcissable et de durcissement subséquent de ladite composition pour l'amener dans un état non-coulant.
caractérisé en ce que l'on utilise comme composition durcissable la composition de la revendication 1.

## Patentansprüche

1. Härtbare Zusammensetzung enthaltend

   (I) von 1-99 Gewichtsteile eines flüssigen Organopolysiloxancopolymeren, hergestellt durch ein Verfahren unter

   (A) Ausbilden einer homogenen Mischung mit einer Säurezahl größer Null und im wesentlichen bestehend aus (a) einer Lösung eines harzartigen Siloxancopolymeren in einem organischen Lösemittel, wobei das Siloxancopolymere an Silizium gebundene Hydroxylgruppen aufweist und im wesentlichen aus $R_3SiO_{1/2}$ -Einheiten und $SiO_{4/2}$ -Einheiten besteht, wobei das Verhältnis von $R_3SiO_{1/2}$ -Einheiten zu $SiO_{4/2}$ -Einheiten 0,6:1 bis 0,9:1 beträgt und R unabhängig eine einwertige Kohlenwasserstoffgruppe bedeutet, und (b) einem flüssigen Organohydrogenpolysiloxan, wobei jede organische Gruppe unabhängig eine einwertige Kohlenwasserstoffgruppe ist, wobei im Mittel mindestens ein an Silizium gebundenes Wasserstoffatom pro Molekül des Organohydrogenpolysiloxans vorhanden ist, und

   (B) Erwärmen der homogenen Mischung, um im wesentlichen das gesamte organische Lösemittel aus ihr zu entfernen,

   (II) von 99-1 Gewichtsteile eines hydroxyfunktionellen Diorganopolysiloxans der mittleren Formel $(HO)R'''_2SiO(R'''_2SiO)_cSiR'''_2(OH)$, in der R''' eine aus Alkyl , Cycloalkyl, Haloalkyl, aromatischen oder halogenierten aromatischen Resten unabhängig ausgewählte Gruppe ist und c einen ausreichenden Wert hat, um dem Diorganopolysiloxan bei 25°C eine Viskosität von ewa 1 bis 1.000.000 Poise zu verleihen,

   (III) von 1-100 Gewichtsteile pro 100 Gewichtsteile der Bestandteile (I) plus (II) eines teilchenförmigen Füllstoffes, ausgewählt aus Aluminiumoxid, Aluminiumoxidmonohydrat oder Aluminiumoxidtrihydrat, und

   (IV) ausreichend Katalysator zum Härten der Zusammensetzung zum nichtfließenden Zustand.

2. Härtbare Zusammensetzung enthaltend

   (I) von 1-99 Gewichtsteile, bezogen auf Feststoffe, eines flüssigen Organopolysiloxancopolymeren, hergestellt durch ein Verfahren unter Ausbilden einer homogenen Mischung mit einer Säurezahl größer Null und im wesentlichen bestehend aus (a) einer Lösung eines harzartigen Siloxancopolymeren in einem organischen Lösemittel, wobei das Siloxancopolymere an Silizium gebundene Hydroxylgruppen aufweist und im wesentlichen aus $R_3SiO_{1/2}$ -Einheiten und $SiO_{4/2}$ -Einheiten besteht, wobei das Verhältnis von $R_3SiO_{1/2}$ -Einheiten zu $SiO_{4/2}$ -Einheiten 0,6:1 bis 0,9:1 beträgt und R unabhängig eine einwertige Kohlenwasserstoffgruppe bedeutet, und (b) einem flüssigen Organohydrogenpolysiloxan, wobei jede organische Gruppe unabhängig eine einwertige Kohlenwasserstoffgruppe ist, wobei im Mittel mindestens ein an Silizium gebundenes Wasserstoffatom pro Molekül des Organohydrogenpolysiloxans vorhanden ist,

   (II) von 99-1 Gewichtstpile eines hydroxyfunktionellen Diorganopolysiloxans der mittleren Formel $(HO)R'''_2SiO(R'''_2SiO)_cSiR'''_2(OH)$, in der R''' eine aus Alkyl, Cycloalkyl, Haloalkyl, aromatischen oder halogenierten aromatischen Resten unabhängig ausgewählte Gruppe ist und c einen ausreichenden Wert hat, um dem Diorganopolysiloxan bei 25°C eine Viskosität von ewa 1 bis 1.000.000 Poise zu verleihen,

   (III) von 1-100 Gewichtsteile pro 100 Gewichtsteile der Bestandteile (I) plus (II) eines teilchenförmigen Füllstoffes, ausgewählt aus Aluminiumoxid, Aluminiumoxidmonohydrat oder Aluminiumoxidtrihydrat, und

   (IV) ausreichend Katalysator zum Härten der Zusammensetzung zum nichtfließenden Zustand.

3. Metallträger, die gehärtete Zusammensetzung nach Anpruch 1 tragend.

4. Verfahren zum Beschichten eines Metallträgers mit einer härtbaren Zusammensetzung und anschließendes Härten der Zusammensetzung zu einem nichtfließenden Zustand,

   **dadurch gekennzeichnet,**

   daß die Zusammensetzung von Anspruch 1 als die härtbare Zusammensetzung verwendet wird.